# EUROPEAN PATENT APPLICATION

(11) **EP 3 767 832 A1**
(43) Date of publication of application: **20.01.2021**
(21) Application number: 19186347.1
(22) Date of filing: 15.07.2019
(51) Int. Cl.: H03M 7/30, H03M 7/40

(54) **PERMUTATION-BASED CODING FOR DATA STORAGE AND DATA TRANSMISSION**

(71) Applicant: USE-256 B.V., 7553 AE Hengelo (NL)
(72) Inventor: De Froe, Johannes Gerardus, 7553 AE HENGELO (NL)
(74) Representative: De Vries & Metman

(57) **Abstract**

Methods of encoding and decoding data are described wherein, the method comprises: receiving a data file or data stream and dividing the data file or data stream in one or more data blocks, each data block having a predetermined size N and comprising a sequence of data units, e.g. byte values; and, iteratively encoding the data file into an encoded data file based on a permutation function and a dictionary of permutation indices, preferably the encoded data file having a size that is equal to or smaller than the size of a data block, wherein iteratively encoding the data file comprises: generating a first ordered data block based on a first data block of the one or more data blocks; determining a first permutation index by providing the first data block and the first ordered data block to an input of the permutation function; determining a dictionary index representing a location in the dictionary in which the first permutation index is stored; generating a second ordered data block based on a second data block, the second data block representing symbols or values of the first ordered data block; determining a second permutation index by providing the second block and the second ordered block to the input of the permutation function; and, determining an encoded block comprising the dictionary index, the second ordered data block and the second permutation index.

## Description

### Field of the invention

The invention relates to permutation-based coding for data storage and data transmission, and in particular, though not exclusively, to methods and systems for permutation-based coding for data storage and data transmission and to a computer-program product using such methods.

### Background of the invention

Currently the amount of data used in everyday processes and services is growing exponentially. These developments have made data coding algorithms indispensable for handling, e.g. storing, processing and transmitting large amounts of data. Two important classes of coding algorithms are data compression algorithms and data encryption algorithms. Data compression algorithms are configured to remove redundancy in data files so that data can be stored more efficiently and transmitted with reduced bandwidth. In many cases, data compression needs to be lossless, i.e. no information is lost during compression. Data encryption algorithms are configured to secure access to the data in order to prevent unauthorized access to the data.

Typically, when both secure and efficient data storage and transmission is needed, a data compression algorithm is used in combination with an encryption technique. Such combined use of algorithm makes the data processing computation intensive. The effect of encryption operations may have a conflicting effect on compression operations. Moreover, the more elevated the level of compression and the level of security that is required, the more complex the algorithms which will even increase the computation burden further, thereby inhibiting commercial applications. For commercial applications, a coding algorithm needs to be fast, flexible to handle different types of data and data should have predictable lengths (format) so that they can be handled by storage or transmission systems. These requirements will often lead to a compromise in terms of compression and security level.

Some of the aforementioned problems may be solved by introducing new technologies, like cloud computing and optical fiber, which allow ever increasing data storage and data transmission. However, implementation of such technologies is typically limited to well-developed geographical areas that have a suitable infrastructure, while access to such high-performance technologies in more remote areas is often not available. Moreover, even if a suitable infrastructure is available, often general encryption schemes like AES cannot be used in certain important applications like video because these encryption schemes interfere with the requirements for high-quality video transmission such as speed and high data compression. For that reason, digital right management (DRM) schemes are used for secure distribution of video.

The Burrows-Wheeler Transform is a block-sorting coding scheme in which data in a block are rearranged based on permutations so that the coded data can be efficiently compressed using a conventional compression scheme, e.g. run-length encoding. BWT is primarily a pre-processing step for increasing the compression of a data block by a conventional compression scheme. Permutation techniques are also used in US8189664, which describes a lossless permutation-based encryption/compression method for video data. Similar permutation-based coding schemes for video coding are described by A. Mihnea, "Permutation-based data compression", PhD thesis, December 2011. These algorithms are specially adapted to video coding and cannot be readily applied to more generic coding applications in which a coding scheme should be able to handle any type of data file or data stream.

Hence, from the above it follows that there is a need in the art for generic coding tools that allow storage and transmission of large amounts of information in an efficient and secure way. In particular, there is a need in the art for generic coding algorithms that allow different types of data to be coded into a data format for efficient and secure data storage and data transmission for a large variety of applications.

### Summary of the invention

As will be appreciated by one skilled in the art, aspects of the present invention may be embodied as a system, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Functions described in this disclosure may be implemented as an algorithm executed by a microprocessor of a computer. Furthermore, aspects of the present invention may take the form of a computer program product embodied in one or more computer readable medium(s) having computer readable program code embodied, e.g., stored, thereon.

Any combination of one or more computer readable medium(s) may be utilized. The computer readable medium may be a computer readable signal medium or a computer readable storage medium. A computer readable storage medium may be, for example, but not limited to, an electronic, magnetic, optical, electromagnetic, infrared, or semiconductor system, apparatus, or device, or any suitable combination of the foregoing. More specific examples (a non-exhaustive list) of the computer readable storage medium would include the following: an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a magnetic storage device, or any suitable combination of the foregoing. In the context of this document, a computer readable storage medium may be any tangible medium that can contain, or store a program for use by or in connection with an instruction execution system, apparatus, or device.

A computer readable signal medium may include a propagated data signal with computer readable program code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

Program code embodied on a computer readable medium may be transmitted using any appropriate medium, including but not limited to wireless, wireline, optical fiber, cable, RF, etc., or any suitable combination of the foregoing. Computer program code for carrying out operations for aspects of the present invention may be written in any combination of one or more programming languages, including an object-oriented programming language such as Java(TM), Smalltalk, C++ or the like and conventional procedural programming languages, such as the "C" programming language or similar programming languages. The program code may execute entirely on the user's computer, partly on the user's computer, as a stand-alone software package, partly on the user's computer and partly on a remote computer, or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described below with reference to flowchart illustrations and/or block diagrams of methods, apparatus (systems), and computer program products according to embodiments of the invention. It will be understood that each block of the flowchart illustrations and/or block diagrams, and combinations of blocks in the flowchart illustrations and/or block diagrams, can be implemented by computer program instructions. These computer program instructions may be provided to a processor, in particular a microprocessor or central processing unit (CPU), of a general purpose computer, special purpose computer, or other programmable data processing apparatus to produce a machine, such that the instructions, which execute via the processor of the computer, other programmable data processing apparatus, or other devices create means for implementing the functions/acts specified in the flowchart and/or block diagram block or blocks.

These computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks. Additionally, the Instructions may be executed by any type of processors, including but not limited to one or more digital signal processors (DSPs), general purpose microprocessors, application specific integrated circuits (ASICs), field programmable logic arrays (FP- GAs), or other equivalent integrated or discrete logic circuitry.

The flowchart and block diagrams in the figures illustrate the architecture, functionality, and operation of possible implementations of systems, methods and computer program products according to various embodiments of the present invention. In this regard, each block in the flowchart or block diagrams may represent a module, segment, or portion of code, which comprises one or more executable instructions for implementing the specified logical function(s). It should also be noted that, in some alternative implementations, the functions noted in the blocks may occur out of the order noted in the figures. For example, two blocks shown in succession may, in fact, be executed substantially concurrently, or the blocks may sometimes be executed in the reverse order, depending upon the functionality involved. It will also be noted that each block of the block diagrams and/or flowchart illustrations, and combinations of blocks in the block diagrams and/or flowchart illustrations, can be implemented by special purpose hardware-based systems that perform the specified functions or acts, or combinations of special purpose hardware and computer instructions.

In an aspect, the invention may relate to a method of encoding data by an encoding apparatus, the method comprising: receiving a data file and dividing the data file or data stream in one or more data blocks, each data block having a predetermined size N and comprising a sequence of data units, e.g. byte values; and, iteratively encoding the data file into a data key based on a first permutation function and a first dictionary of permutation indices, preferably the encoded data file having a size that is equal to or smaller than the size of a data block.

In an embodiment, iteratively encoding the data file may comprise one or more encoding iterations, wherein each encoding iteration may include: generating a first ordered data block based on a first data block of the one or more data blocks; determining a first permutation index based on the first data block and the first ordered data block, the generating including providing the first data block and the first ordered data block to an input of the first permutation function; determining a dictionary index representing a location in the first dictionary in which the first permutation index is stored; generating a second ordered data block based on a second data block, the second data block representing symbols or values of the first ordered data block; determining a second permutation index based on the second block and the second ordered block, the determining including providing the second block and the second ordered block to the input of the first permutation function; and, determining an encoded data block comprising the dictionary index, the second ordered data block and the second permutation index.

The lossless coding schemes described in the embodiments of this application allow encoding of any file type (.exe, .bin, .mp3, .mpeg, .wav, etc.) into a data key of a predetermined size, e.g. N bytes, using a permutation function that transforms a data block (a permutation of an ordered block, i.e. an ordered sequence of symbols or values) into a permutation index. In an embodiment, during encoding, the algorithm may build a dictionary of permutation indices. In another embodiment, the algorithm may use an already existing dictionary of permutation indices. A decoding algorithm may use the same dictionary that was used during encoding or a directory that at least comprises the permutation indices that were also contained in the directory that was used by the encoder to encode the data file. Further, it may use a permutation function that allows a permutation index of an ordered data block to be transformed into a permutation, so that the original data block can be recovered without any loss.

During encoding, a library of permutation indices will be built. The more data is encoded, the slower the library will grow and after encoding a large enough amount of data, the size of the dictionary will no longer grow. Such fully grown dictionary may be used by encoding and decoding devices to encode and securely distribute large data files based on a small data key.

The coding algorithm that is used in the embodiments of this application is not a conventional compression or encryption algorithm. On the contrary, it combines the advantages of both compression and encryption, providing both secure and efficient storage and distribution of data file. The coding algorithm offers a unique method of storing and restoring data. While the amount of data to transport data is kept to a minimum, large amounts of data can be relayed using a very small footprint, with no loss of data. At both ends of the transmission, the sender and the receiver will need to have the same dictionary.

The main idea behind the coding algorithm is to store commonly used data patterns in data files only once in the form of permutations. The algorithm treats each data file as sequence of values or symbols irrespective of its type. By treating a data block as a sequence values or symbols, it is possible to encode a data block in to an encoded data block that has a smaller size than the data block. This also opens the possibility to divide a data file into data blocks of equal size, to encode the data blocks into encoded data blocks and to use the encoded data blocks as a data file for a next encoding iteration (i.e. divide the data file into blocks and encode each block). This way, the data file can be iteratively encoded into a data key of a predetermined size, e.g. the size of a data block or smaller.

A further benefit of the coding schemes described in this application is that the dictionary and the data key represent the original data in a fully scrambled way which cannot be recovered without the dictionary, a data key and the coding algorithms. That means that the original data file cannot be restored on the basis of the dictionary without the corresponding data key and the decoding algorithm.

In an embodiment, the generating a first ordered data block may include: determining a frequency, e.g. the number of occurrences, for each data value in the data block; and, ordering the determined frequencies in a sequence of values in a hierarchical order, e.g. increasing or decreasing order.

In an embodiment, before generating the first ordered data block, converting the data units in the first data block into ascii code, preferably converting data units, for example byte values, of the first data block into ascii codes.

Thus, before sorting and ordering the first data block, byte values may be converted to ascii code. For example, the number 255 may be may be represented by 0xFF in hexadecimal notation. This hexadecimal number may be subsequently transformed into two ascii codes 70 70, i.e. the ascii code for the symbol F in decimal notation. Although such transformation would lead to block sizes that are twice the size of the original bock size, it nevertheless may lead to a substantial improvement in coding efficiency (a factor of 10 or more). This is because a byte value may represent 255 different numbers, whereas the ascii code only 16 (namely the ascii codes for 0-9 and a-f) so that the permutation indices and the ordering process can be determined much faster.

In an embodiment, determining a dictionary index may include: determining if the first permutation index is already stored in the dictionary; if the first permutation index is not stored in the dictionary, stored the first permutation index in the dictionary and receive the dictionary index associated with the first permutation index; or, if the first permutation index is stored in the directory, receive the dictionary index associated with the first permutation index.

In an embodiment, iteratively encoding the data file may comprise: generating iteration information, the iteration information providing information about the number of encoding iterations needed for encoding the data file.

In an embodiment, the process of iteratively encoding the data file into an encoded data file may be stopped if the size of the encoded data file is equal to or smaller than a predetermined size, preferably the size of a data block.

In an embodiment, the data file may be a multimedia file, such as a video file; and/or, wherein the data stream is a multimedia stream, such as a video stream.

In an aspect, the invention may relate to a method of decoding an encoded data file by decoding apparatus, the encoded data file being encoded by an encoder apparatus into a data key based on a first directory of permutation indices and a first permutation function, wherein the method may comprise: receiving a data key, the data key comprising a dictionary index, an ordered data block and a permutation index, and, optionally, iteration information; and, iteratively decoding the data key into a decoded data file based a second permutation function and a dictionary of permutation indices.

In an embodiment, iteratively decoding the encoded data file may comprise: receiving an encoded data block, the encoded data block comprising a dictionary index associated with first permutation index, a first ordered data block and a second permutation index; retrieving the first permutation index from a dictionary using the dictionary index; determining a first data block based on the first ordered data block and the second permutation index, the determining including providing the first ordered data block and the second permutation block to the input of the second permutation function; and, using the first data block as a second ordered data block, and determining an original data block based on the second ordered data block and the first permutation index, the determining including providing the second ordered data block and the first permutation block to the input of the second permutation function.

In an embodiment, the second dictionary may comprise the same permutation indices as the permutation indices of a first dictionary that was used by an encoder apparatus that was used to encode the data file into the data key.

In an aspect, the invention may relate to an encoding apparatus comprising: a computer readable storage medium having at least part of a program embodied therewith; and, a computer readable storage medium having computer readable program code embodied therewith, and a processor, preferably a microprocessor, coupled to the computer readable storage medium, wherein responsive to executing the computer readable program code, the processor is configured to perform executable operations comprising: receiving a data file and dividing the data file or data stream in one or more data blocks, each data block having a predetermined size N and comprising a sequence of data units, e.g. byte values; and, iteratively encoding the data file into a data key based on a first permutation function and a first dictionary of permutation indices, preferably the encoded data file having a size that is equal to or smaller than the size of a data block.

In an embodiment, iteratively encoding the data file may comprise one or more encoding iterations, each encoding iteration including: generating a first ordered data block based on a first data block of the one or more data blocks; determining a first permutation index based on the first data block and the first ordered data block, the generating including providing the first data block and the first ordered data block to an input of the first permutation function; determining a dictionary index representing a location in the first dictionary in which the first permutation index is stored; generating a second ordered data block based on a second data block, the second data block representing symbols or values of the first ordered data block; determining a second permutation index based on the second block and the second ordered block, the determining including providing the second block and the second ordered block to the input of the first permutation function; and, determining an encoded data block comprising the dictionary index, the second ordered data block and the second permutation index.

In an embodiment, generating a first ordered data block may include: determining a frequency, e.g. the number of occurrences, for each data value in the data block; and, ordering the determined frequencies in a sequence of values in a hierarchical order, e.g. increasing or decreasing order.

In an embodiment, before generating the first ordered data block, converting the data units in the first data block into ascii code, preferably converting data units, for example byte values, of the first data block into ascii codes.

In an embodiment, determining a dictionary index may include: determining if the first permutation index is already stored in the dictionary; if the first permutation index is not stored in the dictionary, stored the first permutation index in the dictionary and receive the dictionary index associated with the first permutation index; or, if the first permutation index is stored in the directory, receive the dictionary index associated with the first permutation index.

In an embodiment, iteratively encoding the data file may comprise generating iteration information, the iteration information providing information about the number of encoding iterations needed for encoding the data file.

In an embodiment, the process of iteratively encoding the data file into an encoded data file may be stopped if the size of the encoded data file is equal to or smaller than a predetermined size, preferably the size of a data block.

In a further aspect, the invention may relate to a decoding apparatus comprising: a computer readable storage medium having at least part of a program embodied therewith; and, a computer readable storage medium having computer readable program code embodied therewith, and a processor, preferably a microprocessor, coupled to the computer readable storage medium, wherein responsive to executing the computer readable program code, the processor is configured to perform executable operations comprising: receiving a data key, the data key comprising a dictionary index, an ordered data block and a permutation index, and, optionally, iteration information; iteratively decoding the data key into a decoded data file based a second permutation function and a dictionary of permutation indices.

In an embodiment, iteratively decoding the encoded data file may comprise: receiving an encoded data block, the encoded data block comprising a dictionary index associated with first permutation index, a first ordered data block and a second permutation index; retrieving the first permutation index from a dictionary using the dictionary index; determining a first data block based on the first ordered data block and the second permutation index, the determining including providing the first ordered data block and the second permutation block to the input of the second permutation function; and, using the first data block as a second ordered data block, and determining an original data block based on the second ordered data block and the first permutation index, the determining including providing the second ordered data block and the first permutation block to the input of the second permutation function.

In an embodiment, the second dictionary comprises the same permutation indices as the permutation indices of a first dictionary that was used by an encoder apparatus that was used to encode the data file into the data key.

The invention will be further illustrated with reference to the attached drawings, which schematically will show embodiments according to the invention. It will be understood that the invention is not in any way restricted to these specific embodiments.

### Brief description of the drawings

**Fig. 1** depicts a permutation table for an ordered sequence of symbols.
**Fig. 2A** and **2B** depict two permutation function which are used in the embodiments in this application.
**Fig. 3** depicts a first part of an encoding process according to an embodiment of the invention.
**Fig. 4** depicts a second part of an encoding process according to an embodiment of the invention.
**Fig. 5** depicts the result of the encoding process according to an embodiment of the invention.
**Fig. 6** depicts a third part of an encoding process according to an embodiment of the invention.
**Fig. 7** depicts a flow diagram of an encoding process according to an embodiment of the invention.
**Fig. 8** depicts a first part of a decoding process according to an embodiment of the invention.
**Fig. 9** depicts a second part of a decoding process according to an embodiment of the invention.
**Fig. 10** depicts a flow diagram of a decoding process according to an embodiment of the invention.
**Fig. 11** depicts a schematic of a video encoding and decoding system that may use the techniques described in this application.

### Detailed description

The aim of the embodiments described in this application are coding algorithms based on permutation functions for efficiently and securely storing and transmitting data. A permutation is a reordering of an ordered sequence of symbols or values, which plays an important role in algorithms. Different permutations of an ordered sequence may be indexed by a unique permutation index. This way, a sequence of data (values or symbols) may be regarded as a permutation which can be represented by an ordered sequence and a permutation index. It has been surprisingly found that permutation technicques can be used to code data blocks for efficient and secure data storage and transmission, despite the fact that the combination the ordered sequence and the permutation index, as such, may result in a bigger (bit wise) value. For example, the number of permutations for two bytes is 2! = 2, wherein each byte may represent a value between 0 to 255 resulting in 256 * 256 = 65536 combinations. The number of permutations of bits for two bytes is 32896. Hence, whereas the two bytes contain a total of 16 bits, the combination of the permutation index i (i=1,2) and the ordered sequence contain a total of 17 bits, i.e. more bits than the actual 16 bit of the original sequence. Below the permutation-based coding schemes and their advantages are described in more detail within references to the figures.

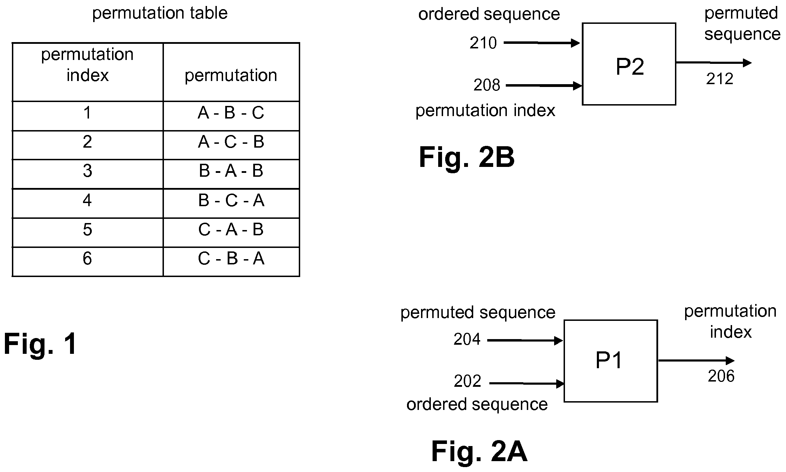

**Fig. 1** depicts an example of a simple permutation table for an ordered sequence of data units, e.g. symbols such as letters or ascii characters, or values such as byte values or hexadecimal values. As shown in this figure, the sequence of letters C - B - A may define a permutation of the ordered sequence of letters A - B - C, wherein the permutation may have permutation index 6. Thus, based on the permutation table, a permutation index can be determined if an ordered sequence and a permutation is known. Similarly, a permutation can be determined if an ordered sequence and a permutation index is known. The permutation table illustrates the relation between an ordered set, a permutation of the ordered set and the permutation index of the permutation. Instead of a table, the index or the permutation may be computed based on a permutation function. Such permutation function can be extended to permutations of an ordered set of N symbols, wherein the size of the table will grow rapidly with N. This functional relation is depicted in **Fig. 2A** and **2B. Fig. 2A** depicts a first permutation function P1, which may receive a permutation **204** and an ordered sequence **202** at its input and returns a permutation index **206** at its output. An example of the first permutation algorithm in pseudo code is provided below wherein the attribute *perm* defines a permutation of an ordered sequence of data units, e.g. symbols or values, the attribute n the ordered sequence of symbols or values and the attribute index represents the permutation index of the attribute permutation:

```
                 begin interface function perm2index(perm,n)
                      dcl perm int[n]
                      dcl n int
                      return int
                  end interface
                  begin function perm2index
                      dcl i,j int
                      dcl d int[]
                      dcl index int
                      copy(src=perm,dest=d)
                      begin loop i = 0,...,n-2
                           begin loop j =i+1,...,n-1
                                if (d[j] .gt. d[i]) d[j] -= 1
                           end loop
                      end loop
                      begin loop i = 0,...,n-2; init index = 0; init j = n-1
                           index = j*(index + d[i])
                           j -= 1
                      end loop
                      return index
                  end function
```

**Fig. 2B** depicts a second permutation function P2, which may receive a permutation index **208** and an ordered sequence **210** at its input and returns a permutation **212** at its output. An example of the permutation algorithm in pseudo code is provided below:

```
                  begin interface function index2perm(index,n)
                      dcl index int
                      dcl n int
                      return int[n]
                  end interface
             begin function index2perm
                      dcl i,j int
                      dcl d int[n]
                      dcl perm int[n]
                      d[n-1] = 0
                      begin loop i = 2,...,n-2; init j = n-2
                           d[j] = modulo(index,i)
                           index /= i
                           j -= 1
                      end loop
                      copy(src=d,dest=perm)
                      begin loop i = 0,...,n-2
                           begin loop j = i+1,....,n-1
                                if (perm[j] .ge. perm[i]) perm[j] += 1
                           end loop
                      end loop
                      return perm
                  end function
```

As will be explained in more detail, these permutation functions may be used in a coding scheme that allows both secure and efficient storage and transmission of data.

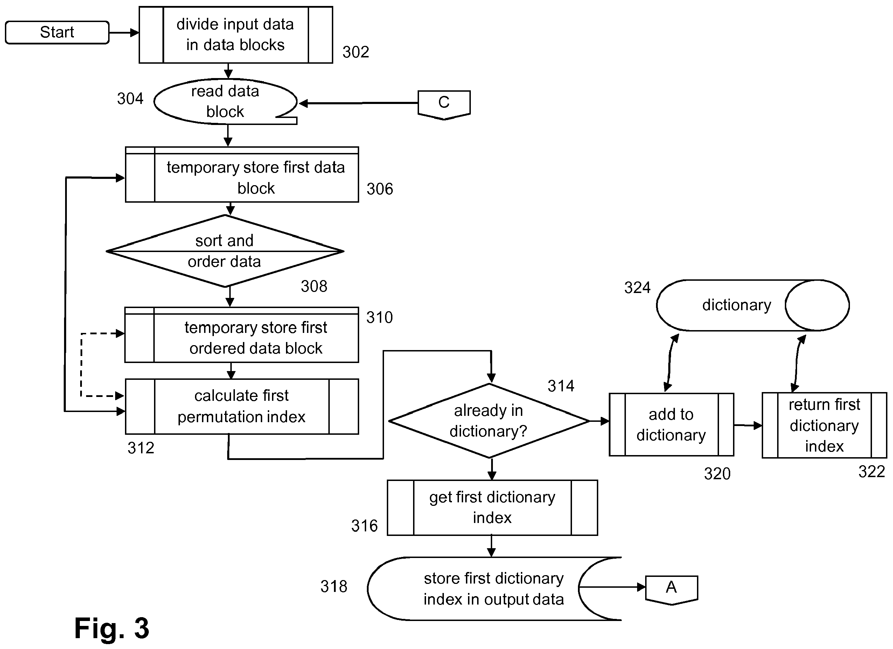

**Fig. 3-5** depict flow diagrams of different phases of an encoding process according to an embodiment of the invention. **Fig. 3** depicts a first phase of the encoding process, wherein in a first step **302** a data file or stream may be divided into data blocks of a predetermined length N. Here, each block may be formatted as an array of N data units, wherein the data units may represent a symbol (letters, numbers, etc.) that can be ordered, e.g. ascii symbols representing numbers and letters, byte values representing a value between 1-255, etc. For example, the block may define an array of 256 bytes (N=256). Each byte value may represent a value between 0 and 255. If the length of the data block is not equal to a multiple of N, the remaining data units may be stored in a temporary buffer. The remaining bytes may be added to the final result when all blocks are processed. For example, a file of 12000 bytes may result into 46 blocks of 256 bytes to be processed, wherein the remaining 224 bytes may be temporary stored.

After dividing the data file or data stream in data blocks, each data block may be processed individually (step **304**), which may include temporarily storing an original first data block (step **306**), sorting and ordering the data units in the first data block based on their value or symbol type (step **308**) and storing the ordered data units as a first ordered data block (step **310**). An algorithm for executing the sorting and ordering step **308** may be configured to process data units of a data block. In an embodiment, the algorithm may be configured to determine the frequency of each data unit (e.g. symbol or byte value) in the data block and ordering the determined frequencies in a sequence of values in a hierarchical order)e.g. increasing, alphabetical or any other suitable order). For example, a first data block formatted as a sequence of byte values may include the following values:
first data block: (255, 216, 255, 224, 0, 16, 74, 70, 73, 70, 0, 1, 1, 0, 0, 1, 0, 1, 0, 0, 255, 219, 0, 67, 0, 3, 2, 2, 3, 2, 2, 3, 3, 3, 3, 4, 3, 3, 4, 5, 8, 5, 5, 4, 4, 5, 10, 7, 7, 6, 8, 12, 10, 12, 12, 11, 10, 11, 11, 13, 14, 18, 16, 13, 14, 17, 14, 11, 11, 16, 22, 16, 17, 19, 20, 21, 21, 21, 12, 15, 23, 24, 22, 20, 24, 18, 20, 21, 20, 255, 219, 0, 67, 1, 3, 4, 4, 5, 4, 5, 9, 5, 5, 9, 20, 13, 11, 13, 20, 20, 20, 20, 20, 20, 20, 20, 20, 20, 20, 20, 20, 20, 20, 20, 20, 20, 20, 20, 20, 20, 20, 20, 20, 20, 20, 20, 20, 20, 20, 20, 20, 20, 20, 20, 20, 20, 20, 20, 20, 20, 20, 20, 20, 20, 20, 20, 20, 20, 255, 192, 0, 17, 8, 3, 132, 6, 64, 3, 1, 34, 0, 2, 17, 1, 3, 17, 1, 255, 196, 0, 31, 0, 0, 1, 5, 1, 1, 1, 1, 1, 1, 0, 0, 0, 0, 0, 0, 0, 0, 1, 2, 3, 4, 5, 6, 7, 8, 9, 10, 11, 255, 196, 0, 181, 16, 0, 2, 1, 3, 3, 2, 4, 3, 5, 5, 4, 4, 0, 0, 1, 125, 1, 2, 3, 0, 4, 17, 5, 18, 33, 49, 65, 6, 19, 81, 97, 7, 34, 113, 20, 50, 129, 145, 161, 8, 35)

The result of the sorting and ordering process is an ordered data block, which may look as follows:
first ordered data block: (28, 19, 9, 17, 12, 13, 4, 4, 5, 3, 4, 7, 4, 4, 3, 1, 5, 6, 3, 2, 56, 4, 2, 1, 2, 0, 0, 0, 0, 0, 0, 1, 0, 1, 2, 1, 0, 0, 0, 0, 0, 0, 0, 0, 0, 0, 0, 0, 0, 1,1,0, 0, 0, 0, 0, 0, 0, 0, 0, 0, 0, 0, 0, 1, 1, 0, 2, 0, 0, 2, 0, 0, 1, 1, 0, 0, 0, 0, 0, 0, 1, 0, 0, 0, 0, 0, 0, 0, 0, 0, 0, 0, 0, 0, 0, 0, 1, 0, 0, 0, 0, 0, 0, 0, 0, 0, 0, 0, 0, 0, 0, 0, 1, 0, 0, 0, 0, 0, 0, 0, 0, 0, 0, 0, 1, 0, 0, 0, 1, 0, 0, 1, 0, 0, 0, 0, 0, 0, 0, 0, 0, 0, 0, 0, 1, 0, 0, 0, 0, 0, 0, 0, 0, 0, 0, 0, 0, 0, 0, 0, 1, 0, 0, 0, 0, 0, 0, 0, 0, 0, 0, 0, 0, 0, 0, 0, 0, 0, 0, 0, 1, 0, 0, 0, 0, 0, 0, 0, 0, 0, 0, 1, 0, 0, 0, 2, 0, 0, 0, 0, 0, 0, 0, 0, 0, 0, 0, 0, 0, 0, 0, 0, 0, 0, 0, 1, 0, 0, 2, 0, 0, 0, 0, 1, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 7)

This ordered data block may be referred to as a first ordered data block. An ordered data block may be formatted to define an ordered sequence of elements, wherein the first element indicates that the original data block contains 28 times the byte value 0, the second element indicates that the original data block contains 19 times the byte value 1, the third element indicates that the original data block contains 9 times the byte value 2, the forth elements 17 times the byte value 3, etc. The first ordered data block may be temporary stored so that it can be used as input data to further encoding steps (step **310**).

In some embodiments, before sorting and ordering the first data block, byte values may be converted to ascii code. For example, the number 255 may be may be represented by 0xFF in hexadecimal notation. This hexadecimal number may be subsequently transformed into two ascii codes 70 70, i.e. the ascii code for the symbol F in decimal notation. Although such transformation would lead to block sizes that are twice the size of the original bock size, it nevertheless may lead to a substantial improvement in coding efficiency. This is due to the fact that that a byte value may represent 255 different numbers whereas the ascii code only 16 (namely the ascii codes for 0-9 and a-f).

In the next step, a first permutation index of the first data block may be calculated by a first permutation function P1 using the first data block and the first ordered data block as input (step **312**). Here, the permutation function may interpret the first ordered data block as a data block comprising a sequence of: 28 zero's, 19 one's, 9 two's, etc. The encoding algorithm may check if the first permutation index is already stored in an indexed list, which hereafter may be referred to as a dictionary (step **314**). In case the index is not stored in the dictionary, the first permutation index may be added to the dictionary (step **320**) and the newly created dictionary index may be returned (step **322**) and stored in an output data storage (step **318**). In case the permutation index is already stored in the dictionary, the dictionary index may be returned (step **316**) and stored in the output data storage (step **318**).

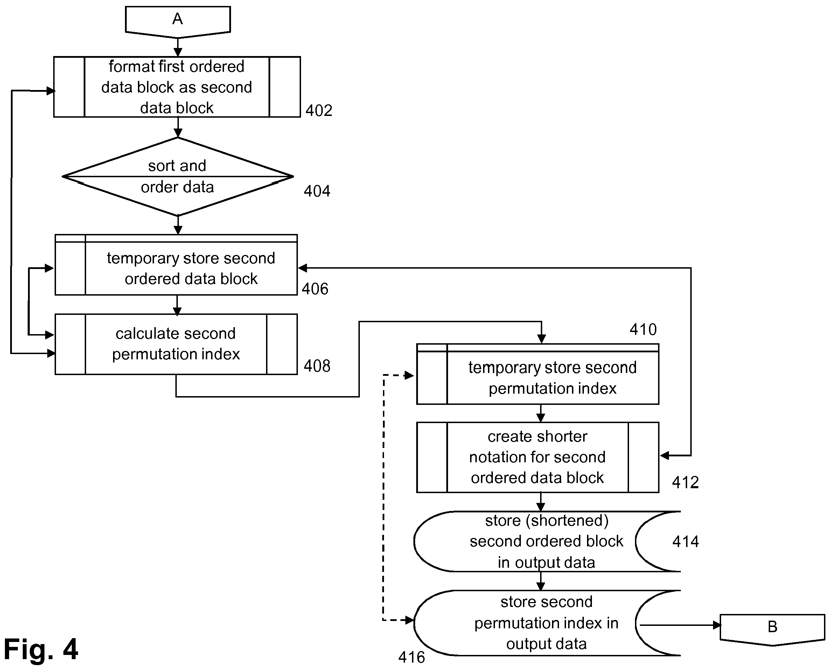

A second phase of the encoding process is shown in **Fig. 4****.** In this phase, the first ordered block may be further processed. The encoding algorithm may first transform the first ordered data block into a format of a byte array (i.e. an array of N bytes each having a certain byte value) that is similar to the data format of the (original) first data block (step **402**). This reformatted first ordered data block may be referred to as a second data block. When transforming the first ordered data block into a second data block of a byte array format, two different situations may be considered. If the first ordered data block includes different elements with non-zero values (e.g. the case in the example of the first ordered data block mentioned above), then the encoding algorithm just transforms the values of the elements of the first ordered data block in to byte values resulting in a second data block comprising a sequence of the following byte values:
second data block: (28, 19, 9, 17, 12, 13, 4, 4, 5, 3, 4, 7, 4, 4, 3, 1, 5, 6, 3, 2, 56, 4, 2, 1, 2, 0, 0, 0, 0, 0, 0, 1, 0, 1,2, 1, 0, 0, 0, 0, 0, 0, 0, 0, 0, 0, 0, 0, 0, 1, 1, 0, 0, 0, 0, 0, 0, 0, 0, 0, 0, 0, 0, 0, 1, 1, 0, 2, 0, 0, 2, 0, 0, 1, 1, 0, 0, 0, 0, 0, 0, 1, 0, 0, 0, 0, 0, 0, 0, 0, 0, 0, 0, 0, 0, 0, 0, 1, 0, 0, 0, 0, 0, 0, 0, 0, 0, 0, 0, 0, 0, 0, 0, 1, 0, 0, 0, 0, 0, 0, 0, 0, 0, 0, 0, 1, 0, 0, 0, 1, 0, 0, 1, 0, 0, 0, 0, 0, 0, 0, 0, 0, 0, 0, 0, 1, 0, 0, 0, 0, 0, 0, 0, 0, 0, 0, 0, 0, 0, 0, 0, 1, 0, 0, 0, 0, 0, 0, 0, 0, 0, 0, 0, 0, 0, 0, 0, 0, 0, 0, 0, 1, 0, 0, 0, 0, 0, 0, 0, 0, 0, 0, 1, 0, 0, 0, 2, 0, 0, 0, 0, 0, 0, 0, 0, 0, 0, 0, 0, 0, 0, 0, 0, 0, 0, 0, 1, 0, 0, 2, 0, 0, 0, 0, 1, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 7)

If however, the first ordered data block includes only one element with a non-zero value, as in the following example:
First ordered data block: (0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 256)

Then, the result of the transformation will be a second block will include a sequence of 256 bytes wherein each byte has the value 0xFF=255:
Second data block: (255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255, 255)

Thereafter, the byte values of the second data block may be processed. In an embodiment, the processing may include determining the frequency of each byte value in the block and ordering the values of the determined frequencies in a sequence of values of increasing order (step **404**). This sorting and ordering process may be similar to the one described above with reference to the first block. The result of the sorting and ordering may be a second ordered data block that has the same data format as the first ordered data block:
Second ordered data block: (204, 23, 8, 3, 6, 2, 1, 2, 0, 1, 0, 0, 1, 1, 0, 0, 0, 1, 0, 1, 0, 0, 0, 0, 0, 0, 0, 0, 1, 0, 0, 0, 0, 0, 0, 0, 0, 0, 0, 0, 0, 0, 0, 0, 0, 0, 0, 0, 0, 0, 0, 0, 0, 0, 0, 0, 1, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0)

The second ordered data block may be temporarily stored for further processing (step **406**). Thereafter, the second data block and the second ordered data block may be used to determine a second permutation index (step **408**), which may also be stored for further processing (step **410**). Here, the permutation function may interpret the second ordered data block as a data block comprising a sequence of 204 zero's, 28 one's, 6 two's, etc. The length of the second permutation index may be variable, so that only the number of bytes needed to store the index are stored.

Further, the algorithm may create a shorter notation (a different data format, which may be referred to as a partition data format) for the second ordered data block (step **412**). Here, the partition data format may include two byte values for each non-zero element in the ordered sequence: a first byte value identifying a location *n* in the ordered sequence (*n*=1,...,N) and a second byte value identifying the number of bytes that have a byte value equal to *n*. Hence, only the non-zero elements are identified in the partition data format, all other elements are zero. example, the partition of the above-mentioned second ordered data block may look as follows:
Partition of second ordered data block: (0, 204, 1, 23, 2, 8, 3, 3, 4, 6, 5, 2, 6, 1, 7, 2, 9, 1, 12, 1, 13, 1, 16, 1, 18, 1, 26, 1, 53, 1)

Thereafter, the partition and the second permutation index may be stored in the output data (steps **414,416**), together with the dictionary index, in a new data block, which may be referred to as an encoded data block.

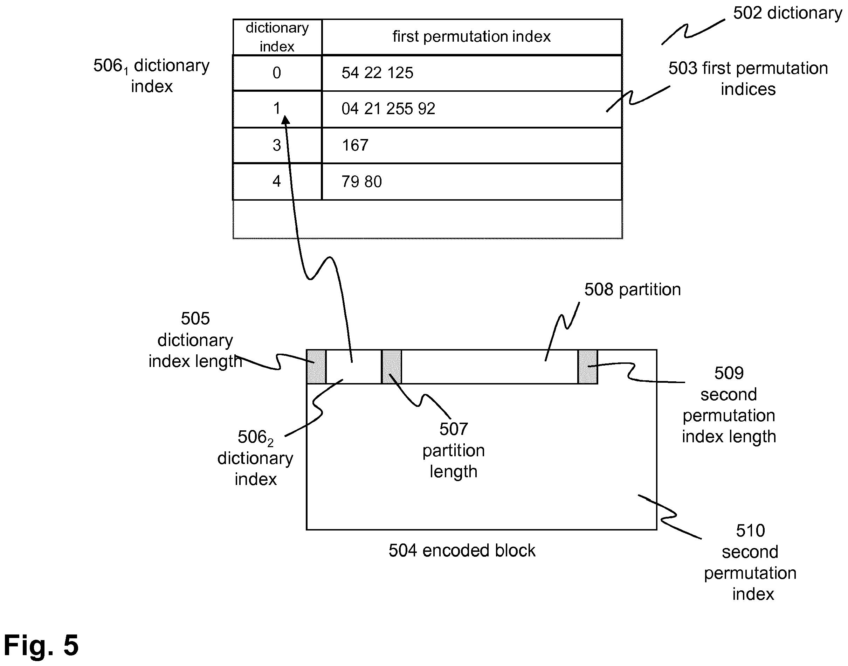

**Fig. 5** depicts the result of the block encoding process as described with reference to **Fig. 2-4**. As described above, the encoder regards data blocks as a permutation of an ordered sequence of data units, wherein the permutation can be identified by a permutation index. Based on the permutation (a data block) and the ordered sequence (an ordered data block), a first permutation function can compute the permutation index.

Similarly, based on the permutation index and the ordered sequence, a second permutation function may compute the permutation. The encoding process encodes a data block (representing a sequence of data units) based on a permutation function that calculates a permutation index, which may be stored in a dictionary **502.** The result of the encoding process is an encoded data block **504** comprising data (e.g. bytes) which are formatted according to a certain data format. In an embodiment, the data format may include a number of data fields including (but not limited to) a dictionary index **506₁,** a partition **508** and a (second) permutation index associated with the partition **510**.

The size of these data field may be variable. Hence, for a decoder to decode an encoded block, the decoder needs to have information about the data fields, e.g. the length of data fields and/or a start or end of data fields. In an embodiment, the data block may include metadata that is required for decoding the encoded data block, e.g. information about the size of the data fields, e.g. size of the dictionary index data field **505**, a size of the partition data field **507** and a size of the second permutation index data field **509**. Alternatively, the metadata (or part of the metadata) may be collected and stored in a separate file associated with the encoded data block.

The dictionary index of the encoded data block may point to an index **506₂** in the dictionary **502**, which is linked to a certain (first) permutation index **503**. The partition and its associated permutation index represents encoded information that is needed to compute an ordered sequence (an order data block) for the first permutation index so that the original data block can be recovered in a decoding process. Thus, the partition and second permutation index form an efficient notation for the first ordered data block, which - together with the first permutation index - is needed to compute the original first data block (the permutation of the first ordered data block) using a permutation function as described with reference to **Fig. 2A** and **2B**. The encoding process may be configured to encode the data block into an encoded data block that is smaller than original data block.

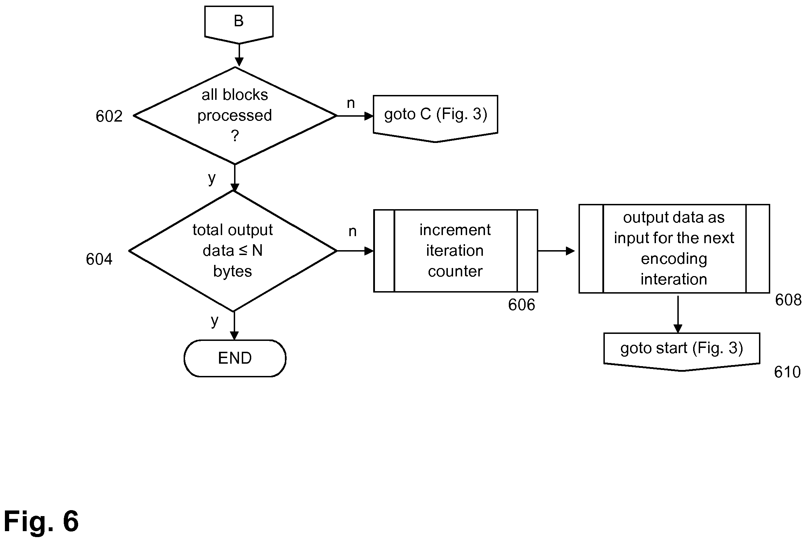

The block encoding scheme may process multiple blocks forming a large data file according to the flow diagram of **Fig. 6**. Here, the block encoding scheme of **Fig. 3** and **4** may be executed in a loop until all data blocks of the data file are encoded into encoded data blocks, which may be stored as output data in a memory (step **602**). If all data blocks are processed, then the algorithm checks if the size of the output data (i.e. the size of all encoded blocks together) is smaller (or equal to or smaller) than a certain size of N bytes, e.g. 256 bytes. If this is not the case, an iteration counter i may be increased (step **604**) and the encoding algorithm will start its next iteration using the output data as input data (step **608**). During each iteration *i* (*i*=1,...,*k*) the dictionary will grow and the size of the output data will decrease. This process may be stopped if the size of the output data is smaller than the size of a data block (e.g. 256 bytes). Hence, after *k* iterations the block encoding process may stop wherein the resulting output data represent a data key of a predetermined size, e.g. 256 bytes or less. The data key may have a data format that is similar to the data format of an encoded data block as described with reference to **Fig. 5**.

Hence, the result of the full encoding process as described with reference to **Fig. 3-6** may be a dictionary (an indexed list of permutation indices), a data key and iteration information for determining (or representing) the number of iterations. In an embodiment, the data format of the encoded data block may include a data field for storing the number of iterations or information for determining the number of iterations. In an other embodiment, the number of iterations may be provides as information (e.g. a key or the like) in a data message that is separated from the data key. The dictionary and the data key may be used in a secure coding scheme, wherein a data source, e.g. video server, may encode a large number of high-resolution video titles based on the encoding scheme as described with reference to **Fig. 1-6**. These video titles may be used to build a dictionary of permutation indices and a plurality of data keys, one for each video title. Data processing devices, e.g. video players, may be provided with a decoder and the dictionary and a data processing device may playback of a video title by requesting a data key of the video title and restoring the original video data using the data key and the dictionary.

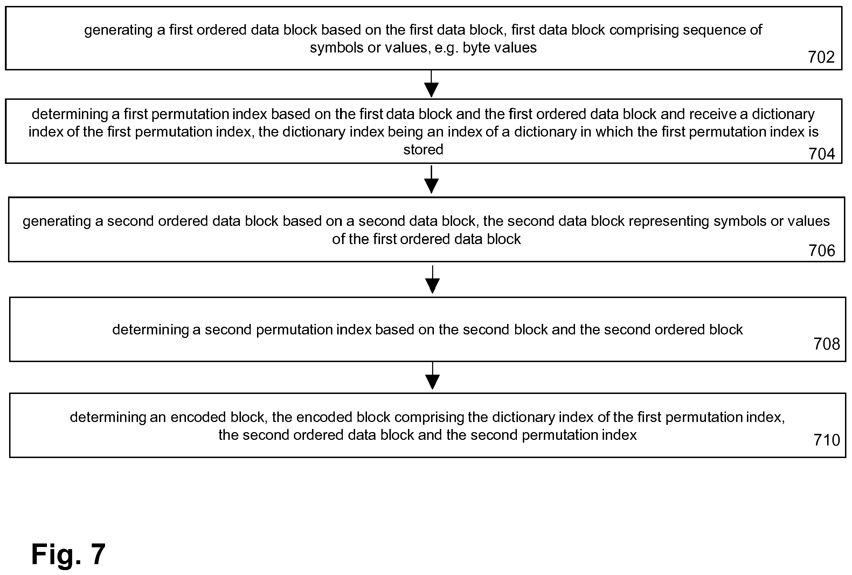

**Fig. 7** depicts a flow diagram of at least part of a permutation-based encoding process according to an embodiment of the invention. In particular, the flow diagram depicts the steps of encoding one of one or more data blocks, which may be generated by dividing a data file in a predetermined number of blocks of a predetermined size, e.g. N bytes or symbols. The coding scheme for encoding a data block into an encoded data block may start with generating a first ordered data block based on the first data block (step **702**), first data block comprising sequence of data units, symbols or values for example byte values. In a next step, a first permutation index based on the first data block and the first ordered data block may be determined and a dictionary index of the first permutation index may be retrieved, wherein the dictionary index is an index of a dictionary in which the first permutation index is stored (step **704**). Further, a second ordered data block may be determined based on a second data block, wherein the second data block may represent symbols or values of the first ordered data block (step **706**). A second permutation index may be determined based on the second block and the second ordered block (step **708**) and an encoded block may be determined, wherein the encoded block comprises the dictionary index of the first permutation index, the second ordered data block and the second permutation index associated with the second ordered data block (step **710**).

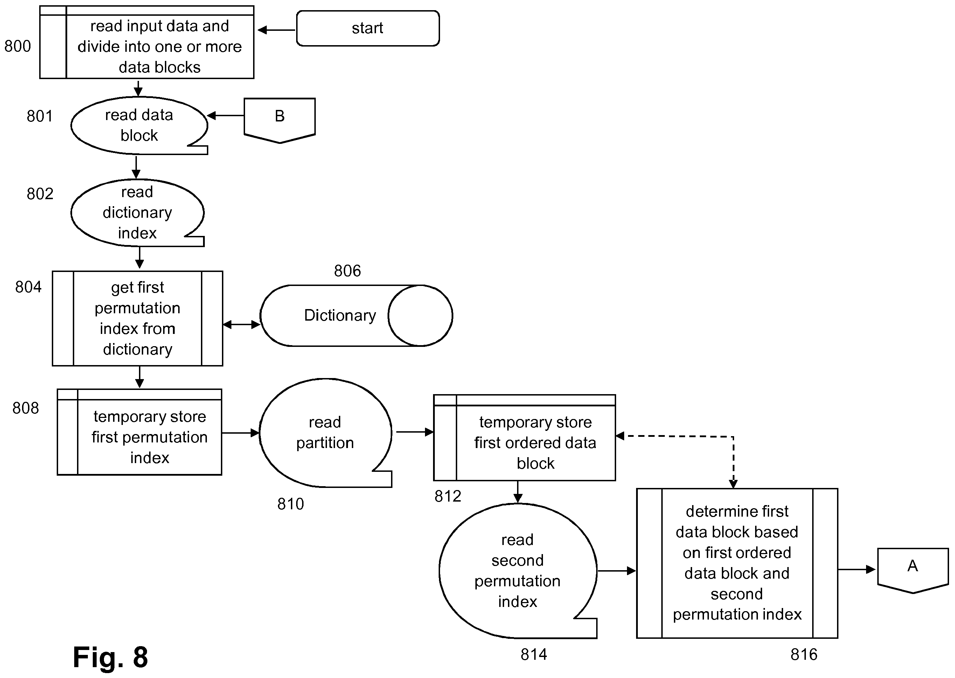

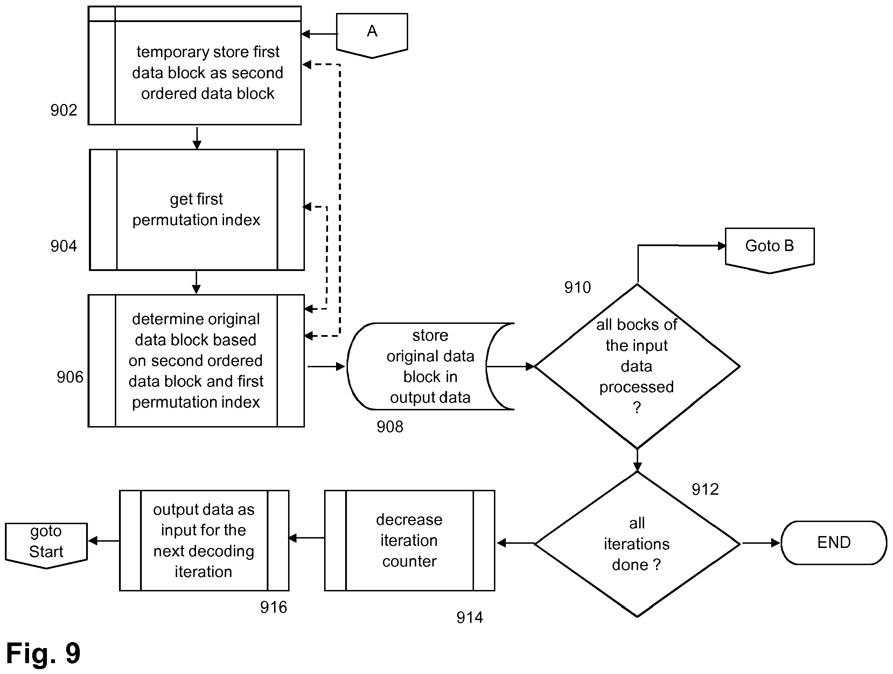

**Fig. 8** and **9** describe a decoding process according to various embodiments of the invention. The decoding process may be executed by a decoder that is provided with a dictionary comprising an indexed list of permutation indices which may be used by the decoder to decode a data key. The dictionary stored in the memory of the decoder may comprise the same permutation indices as the permutation indices of the dictionary that was used by the encoder to generate the data key.

**Fig. 8** depicts a first part of a decoding process according to an embodiment of the invention. In this phase, the decoder may compute an ordered data block which is needed to decode the original data using the dictionary index in the data key.

The decoder may receive a data key having a data format that is known to the decoder. The data format may be similar to the data format described with reference to **Fig. 5**. As a first step **800**, the decoder may receive input data, a data key, and divide the input data into one or more blocks of N bytes. In case of a data key that has been encoded to contain less than N bytes, the decoder may take the data key as one data block. The one or more blocks may be processed according to the decoding process as described hereunder. Similarly, if the input data is an intermediate result of the iterative decoding process (as described hereunder), the input data may be divided in multiple bocks and each of the blocks may be processed according to the decoding process in the subsequent steps.

The decoder may read a data block (step **801**) and determine a dictionary index from a first data field of the data block (step **802**) and use the dictionary index to retrieve a first permutation index, which is stored in the dictionary (steps **804, 806**). The dictionary index may be temporarily stored in a data buffer (step **808**) for further processing. A next data field related to the partition may be read by the decoder and - if necessary - the decoder may expand the partition to first ordered data block, which may be stored in a data buffer (step **812**). A second permutation index associated with the partition may be read from the data key by the decoder (step **814**) and a permutation function may be used to determine a predetermined permutation, a first data block, based on the stored first ordered data block and the second permutation index (step **816**). Further, the decoder may retrieve iteration information, i.e. information for determining the number of iterations the decoder has to execute to decode a data key into the original data file. Here, the first data block may be used by the decoder to restore the original data in a next phase of the decoding process, which is depicted in **Fig. 9****.**

**Fig. 9** depicts a flow diagram of a second part of a decoding process according to an embodiment of the invention. This process may start with temporarily storing the first data block as a second ordered data block (step **902**). Further, the first permutation index may be retrieved (step **904**) and an original data block may be determined based on a permutation function wherein the second ordered block and the first permutation index are provided as input data to the permutation function (step **906**). The original data block may be stored as output data in a buffer (step **908**).

In some embodiments, during encoding, byte values of a block may have been converted to ascii before applying the block-encoding process. In that case, the data units of the decoded original data block may be ascii codes. Hence, in that case, in order to restore the original data, the ascii codes are first transformed back to byte values, before storing the decoded data block as output data.

Thereafter, the decoder may determine if all blocks of input data are processed (step **910**). If this is not the case, then the decoder may start another decoding cycle in which a next encoded block is decoded following the steps above (i.e. **Fig. 8**, steps **801** and further). If all blocks are decoded, then it may use the iteration information, e.g. an iteration counter, to check if all iterations are executed (step **912**). If this is not the case, the iteration counter may be decreased (or increased) (step **914**) and the decoded blocks in the output data may be used as input data and start the decoding process again (step **916**). This process may be continued until the decoding process has executed the number of iterations that were necessary for the encoder to encode the data key. After the last iteration, the output data will represent the recovered original data file.

When executing the above described encoding algorithm an original file may shrink by an average of 19% for each iteration. The first iteration mostly reduces the original more than 19% in size depending on the redundancy in the original, while the dictionary grows if more data is processed. Nevertheless, the growth of the dictionary will slow down and reach an asymptotic maximum when encoding more and more data files. For example, a text file may be encoded starting with an empty dictionary.

**Encoding file: C:\Book1.txt**

| | |
|---|---|
| File#: | 1 |
| Size: | 544606 |
| | |
| Iterations: | 41 |
| Encoding time: | 4,69 sec. 0,08 min |
| Table factor: | 100,00% |
| Table index: | 0,06% |
| Table extent: | 9447 |
| | |
| Total time: | 4,72 sec. 0,08 min. |
| Encoder in: | 2423462 |
| Encoder out: | 499107 |
| Factor: | 4,86 |
| Matches: | 0 |

Thus, the original file has a size of 544606 bytes and after 41 iterations the dictionary has a size of 499107 bytes and the data key has 245 bytes. During the iterations the encoder had to process 2423462 bytes, about four times the size of the original file but the dictionary and the associated data key file (of 245 bytes) are smaller than the original file.

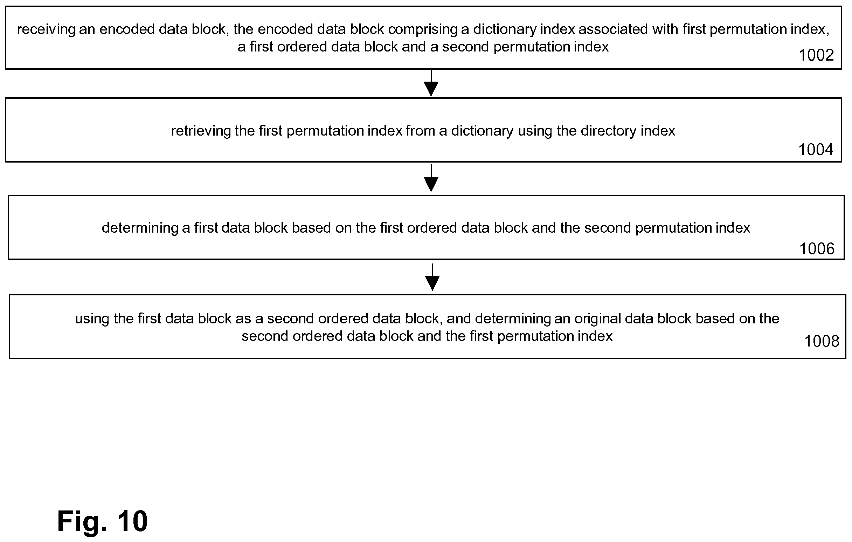

**Fig. 10** depicts a flow diagram of at least part of a permutation-based decoding process according to an embodiment of the invention. In particular, the flow diagram depicts the steps of decoding an encoded data block into one or more data blocks on the basis of a dictionary of permutation indices. The coding scheme for decoding an encoded data block may start with receiving an encoded data block, the encoded data block comprising a dictionary index associated with first permutation index, a first ordered data block and a second permutation index (step **1002**). Then, the first permutation index may be retrieved from a dictionary using the dictionary index (step **1004**). A first data block may be determined based on the first ordered data block and the second permutation index (step **1006**). An original data block may be determined based on a second ordered data block and the first permutation index, wherein the first data block is used as the second ordered data block (step **1008**). As shown in this figure, the decoding process of an encoded block is a short and efficient algorithm for rapidly expanding an encoded data block, in particular a data key in a plurality of data blocks that forms the original data file.

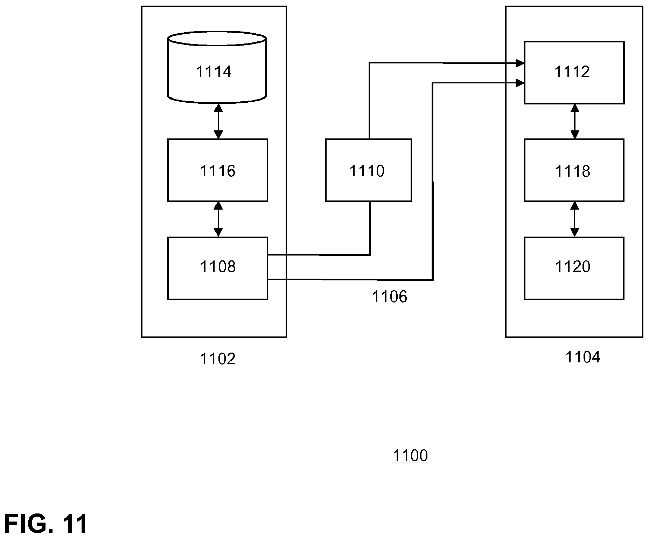

**Fig. 11** depicts a schematic of encoding and decoding system **1100** that may use the encoding and decoding schemes as described in this application. As shown in **Fig. 11**, system **1100** may include a first data processing device **1102**, configured to generate encoded data, in particular a data key, which may be decoded by a second data processing device **1104**, e.g. a video playout device. First and second data processing devices may include any of a wide range of devices, including desktop computers, notebook (i.e., laptop) computers, tablet computers, set-top boxes, telephone handsets such as so-called "smart" phones, so-called "smart" pads, televisions, cameras, display devices, digital media players, video gaming consoles, video streaming device, or the like. In some cases, the data processing devices may be equipped for wireless communication.

The second data processing device may receive the encoded data to be decoded through a transmission channel **1106** or any type of medium or device capable of moving the encoded data from the first video processing device to the second video processing device. In one example, the transmission channel may include a communication medium to enable the first video processing device to transmit encoded data directly to the second video processing device in real-time. The encoded data may be transmitted based on a communication standard, such as a wireless communication protocol, to the second video processing device. The communication medium may comprise any wireless or wired communication medium, such as a radio frequency (RF) spectrum or one or more physical transmission lines. The communication medium may form part of a packet-based network, such as a local area network, a wide-area network, or a global network such as the Internet. The communication medium may include routers, switches, base stations, servers or any other equipment that may be useful to facilitate communication between first and second video processing devices.

Alternatively, encoded data may be sent via an I/O interface **1108** of the first data processing device to a storage device **1110.** Encoded data may be accessed by input an I/O interface **1112** of the second video processing device. Storage device **1110** may include any of a variety of distributed or locally accessed data storage media such as a hard drive, Blu-ray discs, DVDs, CD-ROMs, flash memory, volatile or non-volatile memory, or any other suitable digital storage media for storing encoded video data.

In a further example, the storage device may correspond to a file server or another intermediate storage device that may hold the encoded data generated by the first video processing device. The second data processing device may access stored data from storage device via streaming or downloading. The file server may be any type of server capable of storing encoded video data and transmitting that encoded video data to the second video processing device. Example file servers include a web server (e.g., for a website), an FTP server, network attached storage (NAS) devices, or a local disk drive. The second video processing device may access the encoded video data through any standard data connection, including an Internet connection. This may include a wireless channel (e.g., a Wi-Fi connection), a wired connection (e.g., DSL, cable modem, etc.), or a combination of both that is suitable for accessing encoded video data stored on a file server. The transmission of encoded video data from storage device may be a streaming transmission, a download transmission, or a combination of both.

The techniques of this disclosure are not necessarily limited to wireless applications or settings. The techniques may be applied to coding of multimedia data, e.g. video and/or audio, in support of any of a variety of multimedia applications, such as over-the-air television broadcasts, cable television transmissions, satellite television transmissions, streaming video transmissions, e.g., via the Internet, encoding of digital video for storage on a data storage medium, decoding of digital video stored on a data storage medium, or other applications. In some examples, system **1100** may be configured to support one-way or two-way data transmission to support applications such as data streaming, video playback, video broadcasting, and/or video telephony.

In the example of **Fig. 11**, the first data processing device may further include a data source **1114** and an encoder **1116**. In some cases, I/O interface **1108** may include a modulator/demodulator (modem) and/or a transmitter. The data source may include any type of source such as a video capture device, e.g., a video camera, a video archive containing previously captured video, a video feed interface to receive video from a video content provider, and/or a computer graphics system for generating computer graphics data as the source video, a database, a backup system and/or a combination of such sources. However, the techniques described in this disclosure may be applicable to data coding in general, and may be applied to wireless and/or wired applications.

The data may be encoded by encoder **1116.** The encoded data may be transmitted directly to the second data processing device via I/O interface **1108.** The encoded data may also (or alternatively) be stored onto storage device **1110** for later access by the second data processing device or other devices, for decoding and/or playback.

The second data processing device may further comprise a decoder **1118**, and a display device **1120.** In some cases, I/O interface **1112** may include a receiver and/or a modem. I/O interface **1112** of the second data processing device may receive the encoded data. The encoded data communicated over the communication channel, or provided on storage device **1110**, may include a variety of syntax elements generated by the encoder **1116** for use by a decoder, such as decoder **1118**, in decoding the video data. Such syntax elements may be included with the encoded video data transmitted on a communication medium, stored on a storage medium, or stored a file server.

Display device **1120** may be integrated with, or external to, the second video processing device. In some examples, second video processing device may include an integrated display device and also be configured to interface with an external display device. In other examples, second video processing device may be a display device. In general, display device displays the decoded video data to a user, and may comprise any of a variety of display devices such as a liquid crystal display (LCD), a plasma display, an organic light emitting diode (OLED) display, or another type of display device.

Although not shown in **Fig. 11**, in some aspects, encoder **1116** and decoder **1118** may each be integrated with other encoder and decoder systems, such as state of the art video and/or audio coding systems, and may include appropriate MUX-DEMUX units, or other hardware and software, to handle encoding of both audio and video in a common data stream or separate data streams.

Encoder **1116** and decoder **1118** each may be implemented as any of a variety of suitable encoder circuitry, such as one or more microprocessors, digital signal processors (DSPs), application specific integrated circuits (ASICs), field programmable gate arrays (FPGAs), discrete logic, software, hardware, firmware or any combinations thereof. When the techniques are implemented partially in software, a device may store instructions for the software in a suitable, non-transitory computer-readable medium and execute the instructions in hardware using one or more processors to perform the techniques of this disclosure. Each of encoder **1116** and decoder **1118** may be included in one or more encoders or decoders, either of which may be integrated as part of a combined encoder/decoder (codec) in a respective device.

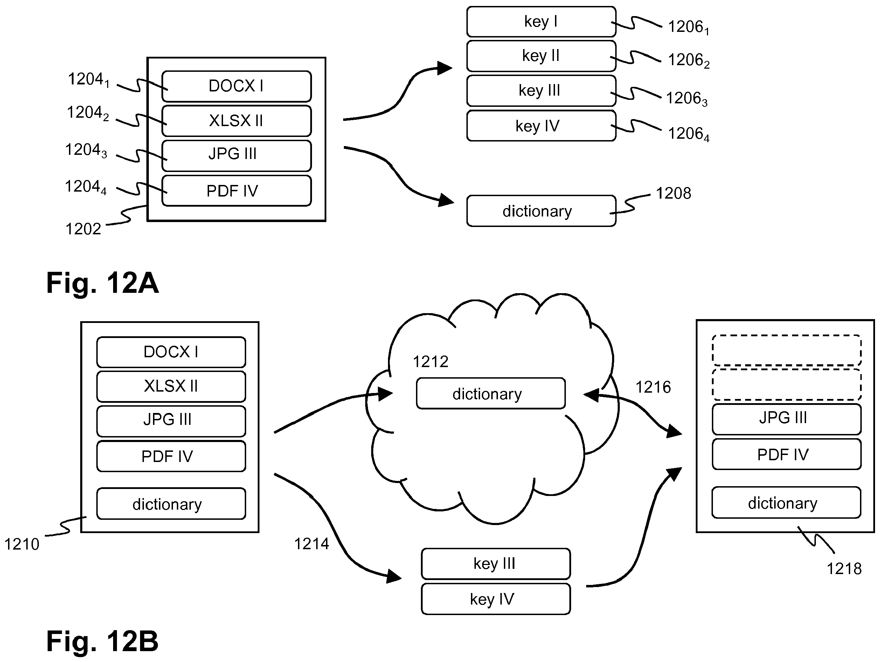

**Fig. 12A** and **12B** depict an exemplary application of the embodiments in this application. As shown in **Fig. 12A**, a data processing device **1202**, e.g. a server or a computer, including a data storage comprising a large number of different files of different formats **1204₁₋₄**. The data processing device may comprise an encoder apparatus as described with reference to the embodiments of this application. The encoder may encode the data file into data keys **1206₁₋₄**, one for each file and a dictionary **1208.**

**Fig. 12B** depicts a possible data distribution system including a first data processing device comprising an encoder apparatus for encoding the data into data keys and a directory and a second data processing device comprising a decoder apparatus. The first data processing device may upload the dictionary to a cloud storage **1212**, which can be accessed by a second data processing device **1218**, e.g. a computer or a mobile device. The second data processing device may download **1216** the dictionary into a memory that can be accessed by a decoder. Further, the first data processing device may be provided with one or more data keys **1214** via another communication channel, which can be used by the decoder apparatus to recover the original data files associated with the data keys.

The techniques of this disclosure may be implemented in a wide variety of devices or apparatuses, including a wireless handset, an integrated circuit (IC) or a set of ICs (e.g., a chip set). Various components, modules, or units are described in this disclosure to emphasize functional aspects of devices configured to perform the disclosed techniques, but do not necessarily require realization by different hardware units. Rather, as described above, various units may be combined in a codec hardware unit or provided by a collection of interoperative hardware units, including one or more processors as described above, in conjunction with suitable software and/or firmware.

The terminology used herein is for the purpose of describing particular embodiments only and is not intended to be limiting of the invention. As used herein, the singular forms "a," "an," and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

The corresponding structures, materials, acts, and equivalents of all means or step plus function elements in the claims below are intended to include any structure, material, or act for performing the function in combination with other claimed elements as specifically claimed. The description of the present invention has been presented for purposes of illustration and description, but is not intended to be exhaustive or limited to the invention in the form disclosed. Many modifications and variations will be apparent to those of ordinary skill in the art without departing from the scope and spirit of the invention. The embodiment was chosen and described in order to best explain the principles of the invention and the practical application, and to enable others of ordinary skill in the art to understand the invention for various embodiments with various modifications as are suited to the particular use contemplated.

## Claims

1. A method of encoding data by an encoding apparatus, the method comprising:
receiving a data file and dividing the data file or data stream in one or more data blocks, each data block having a predetermined size N and comprising a sequence of data units, e.g. byte values; and,
iteratively encoding the data file into a data key based on a first permutation function and a first dictionary of permutation indices, preferably the encoded data file having a size that is equal to or smaller than the size of a data block, wherein iteratively encoding the data file comprises one or more encoding iterations, each encoding iteration including:
- generating a first ordered data block based on a first data block of the one or more data blocks;
- determining a first permutation index based on the first data block and the first ordered data block, the generating including providing the first data block and the first ordered data block to an input of the first permutation function;
- determining a dictionary index representing a location in the first dictionary in which the first permutation index is stored;
- generating a second ordered data block based on a second data block, the second data block representing symbols or values of the first ordered data block;
- determining a second permutation index based on the second block and the second ordered block, the determining including providing the second block and the second ordered block to the input of the first permutation function; and,
- determining an encoded data block comprising the dictionary index, the second ordered data block and the second permutation index.

2. Method according to claim 1 wherein generating a first ordered data block includes:
determining a frequency, e.g. the number of occurrences, for each data value in the data block; and,
ordering the determined frequencies in a sequence of values in a hierarchical order, e.g. increasing or decreasing order.

3. Method according to claims 1 or 2 wherein before generating the first ordered data block, converting the data units in the first data block into ascii code, preferably converting data units, for example byte values, of the first data block into ascii codes.

4. Method according to any of claims 1-3 wherein determining a dictionary index includes:
determining if the first permutation index is already stored in the dictionary;
if the first permutation index is not stored in the dictionary, stored the first permutation index in the dictionary and receive the dictionary index associated with the first permutation index;
if the first permutation index is stored in the directory, receive the dictionary index associated with the first permutation index.

5. Method according to any of claims 1-4 wherein iteratively encoding the data file comprises generating iteration information, the iteration information providing information about the number of encoding iterations needed for encoding the data file.

6. Method according to any of claims 1-5 wherein the process of iteratively encoding the data file into an encoded data file is stopped if the size of the encoded data file is equal to or smaller than a predetermined size, preferably the size of a data block.

7. Method according to any of claims 1-6 wherein the data file is a multimedia file, preferably a video file; and/or, wherein the data stream is a multimedia stream, preferably a video stream.

8. A method of decoding an encoded data file by decoding apparatus, the encoded data file being encoded by an encoder apparatus into a data key based on a first directory of permutation indices and a first permutation function, the method comprising:
receiving a data key, the data key comprising a dictionary index, an ordered data block and a permutation index, and, optionally, iteration information;
iteratively decoding the data key into a decoded data file based a second permutation function and a dictionary of permutation indices, wherein iteratively decoding the encoded data file comprises:
- receiving an encoded data block, the encoded data block comprising a dictionary index associated with first permutation index, a first ordered data block and a second permutation index;
- retrieving the first permutation index from a dictionary using the dictionary index;
- determining a first data block based on the first ordered data block and the second permutation index, the determining including providing the first ordered data block and the second permutation block to the input of the second permutation function; and,
- using the first data block as a second ordered data block, and determining an original data block based on the second ordered data block and the first permutation index, the determining including providing the second ordered data block and the first permutation block to the input of the second permutation function.

9. A method according to claim 8 wherein the second dictionary comprises the same permutation indices as the permutation indices of a first dictionary that was used by an encoder apparatus that was used to encode the data file into the data key.

10. An encoding apparatus comprising:
a computer readable storage medium having at least part of a program embodied therewith; and, a computer readable storage medium having computer readable program code embodied therewith, and a processor, preferably a microprocessor, coupled to the computer readable storage medium, wherein responsive to executing the computer readable program code, the processor is configured to perform executable operations comprising:
receiving a data file and dividing the data file or data stream in one or more data blocks, each data block having a predetermined size N and comprising a sequence of data units, e.g. byte values; and,
iteratively encoding the data file into a data key based on a first permutation function and a first dictionary of permutation indices, preferably the encoded data file having a size that is equal to or smaller than the size of a data block, wherein iteratively encoding the data file comprises one or more encoding iterations, each encoding iteration including:
- generating a first ordered data block based on a first data block of the one or more data blocks;
- determining a first permutation index based on the first data block and the first ordered data block, the generating including providing the first data block and the first ordered data block to an input of the first permutation function;
- determining a dictionary index representing a location in the first dictionary in which the first permutation index is stored;
- generating a second ordered data block based on a second data block, the second data block representing symbols or values of the first ordered data block;
- determining a second permutation index based on the second block and the second ordered block, the determining including providing the second block and the second ordered block to the input of the first permutation function; and,
- determining an encoded data block comprising the dictionary index, the second ordered data block and the second permutation index.

11. Encoding apparatus according to claim 10, wherein generating a first ordered data block includes:
determining a frequency, e.g. the number of occurrences, for each data value in the data block; and,
ordering the determined frequencies in a sequence of values in a hierarchical order, e.g. increasing or decreasing order.

12. Encoding apparatus according to claims 10 and 11, wherein before generating the first ordered data block, converting the data units in the first data block into ascii code, preferably converting data units, for example byte values, of the first data block into ascii codes.

13. Encoding apparatus according to any of claims 10-12, wherein determining a dictionary index includes:
determining if the first permutation index is already stored in the dictionary;
if the first permutation index is not stored in the dictionary, stored the first permutation index in the dictionary and receive the dictionary index associated with the first permutation index;
if the first permutation index is stored in the directory, receive the dictionary index associated with the first permutation index.

14. Encoding apparatus according to any of claims 10-13 wherein iteratively encoding the data file comprises generating iteration information, the iteration information providing information about the number of encoding iterations needed for encoding the data file.

15. Encoding apparatus according to any of claims 10-14 wherein the process of iteratively encoding the data file into an encoded data file is stopped if the size of the encoded data file is equal to or smaller than a predetermined size, preferably the size of a data block.

16. A decoding apparatus comprising:
a computer readable storage medium having at least part of a program embodied therewith; and, a computer readable storage medium having computer readable program code embodied therewith, and a processor, preferably a microprocessor, coupled to the computer readable storage medium, wherein responsive to executing the computer readable program code, the processor is configured to perform executable operations comprising:
receiving a data key, the data key comprising a dictionary index, an ordered data block and a permutation index, and, optionally, iteration information;
iteratively decoding the data key into a decoded data file based a second permutation function and a dictionary of permutation indices, wherein iteratively decoding the encoded data file comprises:
- receiving an encoded data block, the encoded data block comprising a dictionary index associated with first permutation index, a first ordered data block and a second permutation index;
- retrieving the first permutation index from a dictionary using the dictionary index;
- determining a first data block based on the first ordered data block and the second permutation index, the determining including providing the first ordered data block and the second permutation block to the input of the second permutation function; and,
- using the first data block as a second ordered data block, and determining an original data block based on the second ordered data block and the first permutation index, the determining including providing the second ordered data block and the first permutation block to the input of the second permutation function.

17. Decoder apparatus according to claim 16 wherein the second dictionary comprises the same permutation indices as the permutation indices of a first dictionary that was used by an encoder apparatus that was used to encode the data file into the data key.

18. Computer program product comprising software code portions configured for, when run in the memory of a computer, executing the method steps according to any of 1-9.
